(19) **Europäisches Patentamt / European Patent Office / Office européen des brevets**

(11) **EP 1 298 857 B1**

(12) **EUROPEAN PATENT SPECIFICATION**

(45) Date of publication and mention
of the grant of the patent:
**14.11.2007 Bulletin 2007/46**

(51) Int Cl.:
**H04L 12/56** (2006.01)

(21) Application number: **02256616.0**

(22) Date of filing: **24.09.2002**

(54) **Matched broadband switch matrix with active diode isolation**

Angepasste Breitband-Schaltmatrix mit aktiver Diode Isolation

Matrice de commutation à large bande adaptée avec isolation à diode active

(84) Designated Contracting States:
**DE FR GB**

(30) Priority: **25.09.2001 US 962820**

(43) Date of publication of application:
**02.04.2003 Bulletin 2003/14**

(73) Proprietor: **TYCO Electronics Corporation**
**Middletown, Pennsylvania 17057-3163 (US)**

(72) Inventor: **Di Piazza, Gerald Charles**
**Edenton,**
**North Carolina 26932 (US)**

(74) Representative: **Warren, Keith Stanley et al**
**BARON & WARREN**
**19 South End**
**Kensington**
**London W8 5BU (GB)**

(56) References cited:
**EP-A- 0 683 538**          **EP-A- 0 967 680**
**US-A- 4 779 065**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

Switching high speed optical signals can require a switching matrix that is capable of switching broad bandwidth signals that can have both a very high upper cutoff frequency, i.e., 40 GHZ and higher, and a very low cutoff frequency, i.e., 100KHz or lower. In addition, the switch matrix must be able to maintain the signal fidelity over the entire frequency range. To maintain the necessary fidelity, a switch must be properly matched to minimize the mismatch reflections that will occur over the frequency range and, particularly, at the higher frequencies.

Typically, isolation switches have been placed in series with the signal switching devices. The isolation switches have a low "on" resistance and a high "off" resistance. The isolation switches closest to the signal switching device, on the side away from the signal propagation path are switched off to isolate the signal switching device. However, the isolation switches typically have high parasitic reactances that, although ignored at lower frequencies, adversely impact the performance of the switch matrix at high frequencies and lead to generation of amplitude, phase and delay distortions that can cause serious deterioration in bit error rates for high speed data channels.

EP-A-0683538 discloses a microwave crosspoint blocking switch matrix which utilises multilayer stripline and pin diode switching elements to selectively electrically couple and decouple input transmission lines to output transmission lines without severance of the transmission lines and insertion of a series switch. The microwave crosspoint blocking switch matrix assembly employs pin diode arrays coupled to input and output transmission lines at respective crosspoints. In order to route a signal from a specific input line to a selected output line, the pin diode array at the input/output transmission line crosspoint is activated and each transmission line is shorted at points one-quarter wavelength distant from the crosspoint to reflect, ideally, an infinite impedance at the interconnection point. Therefore, a desired signal cannot propagate in any direction except from the selected input line to the desired output line.

It is an aim of the present invention to provide a switch matrix that provides for isolating and matching of the input signals across a very broad bandwidth.

The invention resides in a switch matrix and a method of isolating a switch matrix as set forth in claims 1 and 15 hereof, respectively.

With the invention, the switching connection is isolated by forming two shunt stubs, or lumped circuit equivalents, each having an electrical length such that the input impedance of the shunt stub is high. The shunt stubs are formed on the appropriate input and output signal lines of the switch matrix on the opposite side of the input and output lines from the preferred direction for the propagation of the switched signal. It will be shown in subsequent sections of this disclosure that the use of the shunt stub architecture facilitates simplified biasing of the active isolation devices, provides for broadband isolation of the selected signal transmission path and, together with appropriate spacing of the matrix transmission lines, minimizes the effects of the parasitic reactances of the active signal and isolation switching devices.

In particular, in one embodiment, a switch matrix is disclosed having a plurality of input and output signal lines. Each of the input signal lines has a signal input end and a non-input signal end and each of the output signal lines has a signal output end and a non-output signal end. The switching matrix switches a broadband signal of interest (having a center frequency) between a an input signal line and a signal output line using one of a plurality of signal switches. Each one of the plurality of signal switches is coupled to a single input signal line and a single output signal line. Accordingly, when a selected signal switch is activated, the signal of interest is coupled between the selected input signal line and the selected output signal line.

The switch matrix further includes a plurality of first isolation switches, each of which is associated with a single signal switch. Each of the plurality of first isolation switches are coupled to one of the plurality of output signal lines associated with the single signal switch. The isolation switch is further coupled to ground forming a tuning stub when it is activated. The length of the tuning stub is determined by the spaced apart distance each isolation switch is disposed from the single signal switch. Thus, when the first isolation switch is activated, the portion of the output line between the associated signal switch and the isolation switch forms the tuning stub of the first predetermined length. Preferably, the first predetermined length is equal to a predetermined electrical length of transmission line that is one quarter wavelength of the center frequency of the signal of interest.

The switching matrix also includes a plurality of second isolation switches, each of which is associated with a single signal switch. Each of the second plurality of isolation switches is coupled to one of the plurality of input signal lines associated with the single signal switch. Each of the plurality of isolation switches is further coupled to ground forming a tuning stub. The length of the tuning stub is determined by the spaced apart distance each isolation switch is disposed from the associated signal switch. Thus, when a second isolation switch is activated, the portion of the input line between the associated signal switch and the isolation switch forms the tuning stub of the second predetermined length. Preferably, the second predetermined length is equal to a predetermined electrical length of transmission line that is one quarter wavelength and the center frequency of the signal of interest.

In one aspect of the present invention, the plurality of signal switches and the first and second isolation switches are a plurality of semiconductor switching elements and are selected from the group of switching diodes, thryristors and transistors. In particular, the plurality of switching diodes are a plurality of PIN diodes, the plurality of transistors are a plurality of bipolar junction transistors, and the plurality of transistors are a plurality of field effect transistors.

In another aspect of the present invention, the first and second predetermined electrical length is an odd integer multiple of the quarter-wavelength of the signal of interest. In particular, the first and second predetermined electrical distances are one-quarter wavelength of the signal of interest.

In another embodiment, the first and second stubs are provided for by a plurality of lumped circuit elements that provide the same impedance transforming function as the stub. In particular, the lumped circuit is a pi-section that includes an inductor coupled to a capacitor at each end, where each of the capacitors is further coupled to ground. Alternatively, a pi-section can be formed that includes a capacitor coupled to an inductor at each end, where each of the inductors is further coupled to ground. The use of lumped elements facilitates size matrix reduction relative to the distributed transmission line counterpart.

In order that the invention may be more fully understood, particular embodiments thereof will now be described with reference to the accompanying drawings in which:

> Fig. 1 is a schematic diagram of one embodiment of a switch matrix including the presently described stub tuner;
> Fig. 2 is a schematic diagram of another embodiment of a switch matrix including the presently described stub tuner;
> Fig. 3 is a schematic diagram of a biasing network to bias the isolation circuit included in the switch matrix of Fig.1 and Fig. 2;
> Fig. 4 is a schematic diagram of a lumped circuit equivalent to the stub tuner of Fig. 1 and Fig. 2;
> Fig. 5 is a side view of an implementation of the present invention on a substrate.

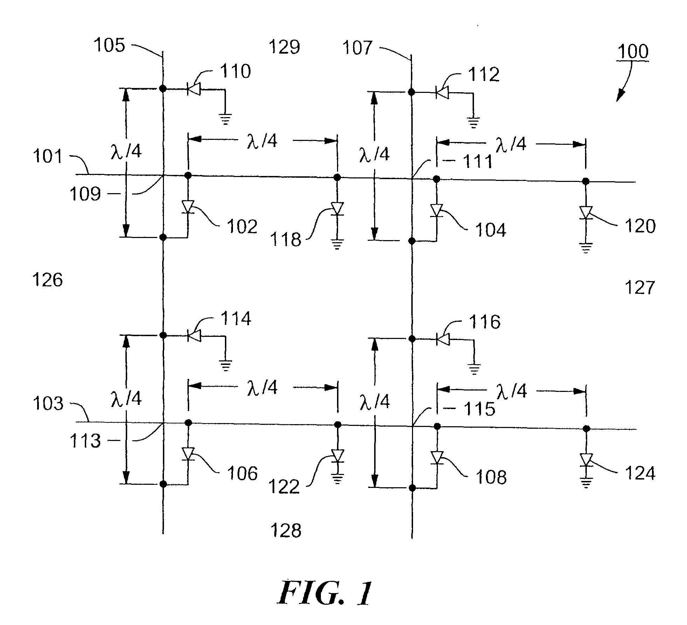

Fig. 1 illustrates one embodiment of a switching matrix 100 incorporating the presently described techniques for isolating a switching junction within the switch matrix. The switching matrix 100 is designed to switch signals having a center frequency $f_0$ and a bandwidth B. In particular switch matrix 100 includes input signal lines 101 and 103 and output signal lines 105 and 107. The input signal lines 101 and 103 include an input signal end 126 and a non-input signal end 127. The output signal lines 105 and 107 include an output signal end 128 and a non-output signal end 129. The cross points 109, 111, 113 and 115 of the input lines 101 and 103 and the output lines 105 and 107 are not electrically connected to one another. Rather, switching diodes 102, 104, 106 and 108, when selected and activated, are used to electrically couple a particular input line to a particular output line. In the illustrative embodiment, switching diode 102 interconnects the cross point 109, switching diode 104 interconnects the cross point 111, switching diode 106 interconnects the cross point 113 and switching diode 108 interconnects the cross point 115.

In the embodiment depicted in Fig. 1, switching diode 102 is associated with shunt diodes 110 and 118, switching diode 106 is associated with shunt diodes 114 and 122, switching diode 104 is associated with isolation diodes 112 and 120, and switching diode 108 is associated with shunt diodes 116 and 124.

The switching diodes 102, 104, 106 and 108 can be selected and activated using any methods known in the art. For example, an external bias network (not shown) may be used to select a particular diode, or the input lines 101 and 103 and output lines 105 and 107 may be appropriately biased using positive and negative voltages in order to forward bias a selected switching diode. Although switching diodes are shown, they are for illustrative purposes only and any form of electronic switch may be used that satisfies the overall system requirements for speed, bandwidth, parasitics and the fidelity of the output signal. For example, other semiconductor switches may be used such as PIN diodes, thryristors, field effect transistors and bipolar junction transistors.

As shown in Fig. 1, each switching diode has two shunt diodes associated therewith. Each shunt diode is coupled at one end to either the input or output line to which the corresponding switching diode is coupled. Each shunt diode is further coupled at the opposite end directly to either ground or coupled to ground via a feed through capacitor (not shown) wherein an external bias network is coupled to the other electrode to select the diode. Each shunt diode, when appropriately selected and activated, will shunt the corresponding input line or output line to ground forming a stub. The point at which each shunt diode is coupled to the corresponding input line or output line is spaced apart from the corresponding switching diode by a predetermined distance. The predetermined distance, which is the physical length of the stub, also determines the electrical length of the stub. The electrical length of the stub is the length of the stub expressed as a multiple or submultiple of the wavelength of the electromagnetic signal of interest that propagates within the medium. In particular, the predetermined distance is selected such that the point at which the shunt diode is coupled to the input line or output line has an electrical length equal to an odd- integer number quarter-wave lengths at the center frequency. In a preferred embodiment, the connection between each shunt diode and the corresponding input or output line has an electrical length of one quarter-wave length at the center frequency.

As is known, a stub acts as a impedance transformer, wherein the input impedance is a function of the load impedance, the impedance of the shorted stub and the length of the shorted stub in terms of the center frequency. As is known, for a terminated transmission line the generalized impedance is given by:

$$Z_1 = Z_O * \frac{Z_L + jZ_O \tan(\beta \ell)}{Z_O + jZ_L \tan(\beta \ell)}$$

where $Z_L$ is the load impedance, $Z_O$ is the impedance of the transmission line and $\beta$l is the wave number. For a quarter wave section of transmission line, $\beta$l equals $\pi/2$, Accordingly, a quarter-wavelength stub reflects the load impedance to the input as:

$$Z_1 = Z_2 \frac{Z_L + jZ_2 \tan(\frac{\pi}{2})}{Z_2 + jZ_L \tan(\frac{\pi}{2})} = \frac{Z_2{}^2}{Z_L} \qquad \text{Eq. 1}$$

where $Z_L$ is the load impedance, $Z_2$ is the characteristic impedance of the stub, If $Z_L$ is zero, i.e., the end of the quarter wavelength stub is a short circuit, then the impedance $Z_1$ is infinite. In practice, the small forward resistance of the shunt diode limits the impedance $Z_1$ to a large, but not infinite, value. Similarly, the reflection coefficient of a quarter wavelength shorted stub is nearly 1, such that any signal incident on the quarter wavelength stub will be nearly entirely reflected therefrom. In addition, by using a shunt diode having a small forward resistance the insertion loss caused by the shunt diode may be minimized.

One advantage of the use of the quarter wavelength shorted stub is the relatively broadband bandwidth of the section in terms of the . In particular, it can be shown that the bandwidth B of a quarter wavelength shorted stub is given by:

$$B = \frac{8 * f_0}{\pi} * \frac{Z_{0S}}{Z_0} \qquad \text{Eq. 2}$$

where B is the bandwidth, $Z_0$ is the characteristic impedance of the transmission line, $Z_{0S}$ is the characteristic impedance of the stub and $f_0$ is the center frequency. In particular, it can be seen from Eq. 2 that the value for $Z_{0S}$ should be greater than or equal to the value of $Z_0$ to avoid the reduction of the bandwidth. When $Z_{0S}$ is equal to $Z_0$ the bandwidth of the quarter wavelength stub is approximately 2.55 times the center frequency.

In the embodiment depicted in Fig. 1, the shunt diodes are selected as having a small forward bias resistance and (low) high frequency bias parasitic reactances at the center frequency. The shunt diodes, which can be any suitable electronic switching device, such as PIN diodes, thyristors, FETs and BJTs, can be activated using preselected voltages on the input lines and output lines such that only one shunt diode is active on each of the input lines and each of the output lines at any given time. It should be noted that in the embodiment depicted in Fig. 1, the selected output line must be selected using a voltage that is at least one shunt-diode voltage-drop lower than ground. Similarly, the selected input line must be selected using a voltage that is at least one shunt-diode voltage-drop higher than ground. Of course, other voltages may be selected depending upon the system requirements provided that the voltages on the input lines and output lines differ in voltage by at least one diode voltage drop. Thus, the particular switching node within the switching matrix will be isolated by the high-impedance/high reflectivity provided by the one-quarter-wavelength shorted stub located on the non-input side 127 and the non-output side 129 of the respective input and output line. Accordingly, a signal propagating on a particular input line that is switched to a selected output line by the corresponding activated switching diode is isolated by the quarter wavelength stubs formed by the activated shunt diodes. Thus, matching the switch and reducing reflections and losses.

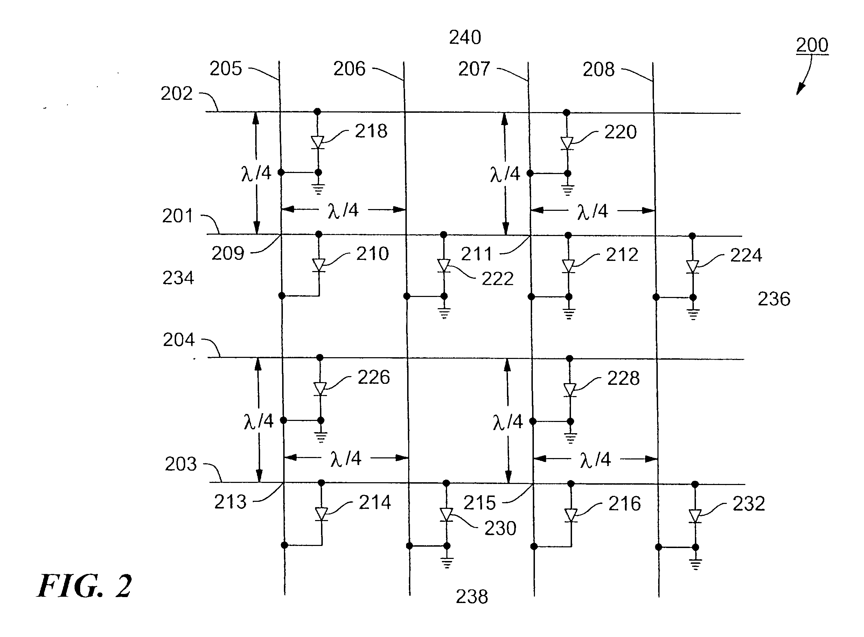

Fig. 2 depicts another embodiment of a switch matrix 200 in which a separate shunt diode selection matrix is used. In this embodiment, a switch matrix 200 includes signal input lines 201 and 203, signal output lines 205 and 207, first shunt diode selection lines 202 and 204, and second shunt diode selection lines 206 and 208. The first shunt diode selection lines 202 and 204 are spaced apart an odd integer number of multiples of a quarter-wavelength from the corresponding signal input lines 201 and 203 respectively. Similarly, the second shunt diode selection lines 206 and 208 are spaced apart an odd integer number of multiples of a quarter-wavelength from the corresponding signal output lines 205 and 207, respectively. As described above, the cross points 209, 211, 213 and 215 are not electrically connected to one another. Rather, switching diodes 210, 212, 214 and 216, when selected and activated, are used to electrically interconnect the corresponding input signal line to a corresponding output signal line. In the illustrative embodiment, switching diode 210 interconnects the cross point 209, switching diode 212 interconnects the cross point 211, switching diode 214 interconnects the cross point 213, and switching diode 216 interconnects the cross point 215. In this embodiment, the first shunt diode selection lines 202 and 204 are selected by a voltage that is at least one shunt-diode voltage drop greater than the selection voltage used to select a corresponding signal output line 205 and 207. Similarly, the second shunt diode selection lines 206 and 208 are selected by a voltage that is at least one shunt-diode voltage drop less than the selection voltage used to select a corresponding signal output line 205 and 207.

As discussed above, each of the first shunt diode selection lines 202 and 204 are spaced apart from the corresponding signal input lines 201 and 203 by an electrical length equal to an odd integer number of quarter wavelengths at the center frequency. In the embodiment depicted in Fig. 2, the electrical length is preferably one quarter wavelength at the center frequency of the signal of interest. In this way, when selected and activated, a selected shunt diode couples the selected output signal line to ground a quarter wavelength away from the selected signal input line, forming a shorted quarter wavelength stub, which as described above, has an ideal impedance of infinity and a reflection coefficient of one.

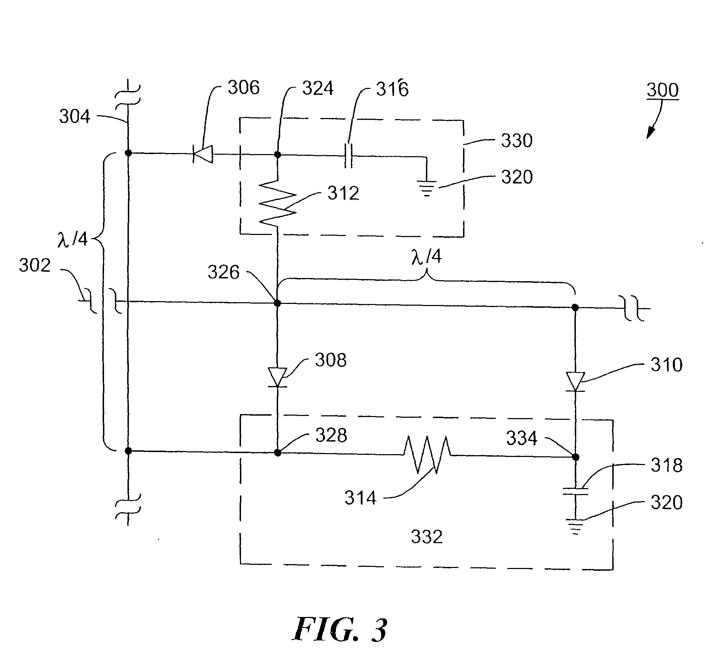

Fig. 3 depicts one embodiment of a bias network suitable for providing the necessary bias voltages to the various switches. In particular, Fig. 3 depicts a resistor-capacitor network that provides the necessary biasing for the shunt and switching diodes. The resistor-capacitor network 300 includes a signal input line 302 and a signal output line 304. As above, the signal input line 302 and the signal output line 304 are not electrically coupled together. Switching diode 308, when activated, provides a low insertion loss connection therebetween. The switching diode has associated therewith two shunt diodes 306 and 310. Each of the shunt diodes 306 and 310 are coupled to the corresponding output line 304 and input line 302 one quarter wavelength, at the center frequency of the signal of interest, away from the switching diode 308. A bias network 330 biases the shunt diode 306 and includes resistor 312 coupled between the nodes 324 and 326, and capacitor 316 coupled between node 324 and ground 320. A bias network 332 biases the shunt diode 310 and includes resistor 314 coupled between the nodes 328 and 334, and capacitor 318 coupled between node 334 and ground 320.

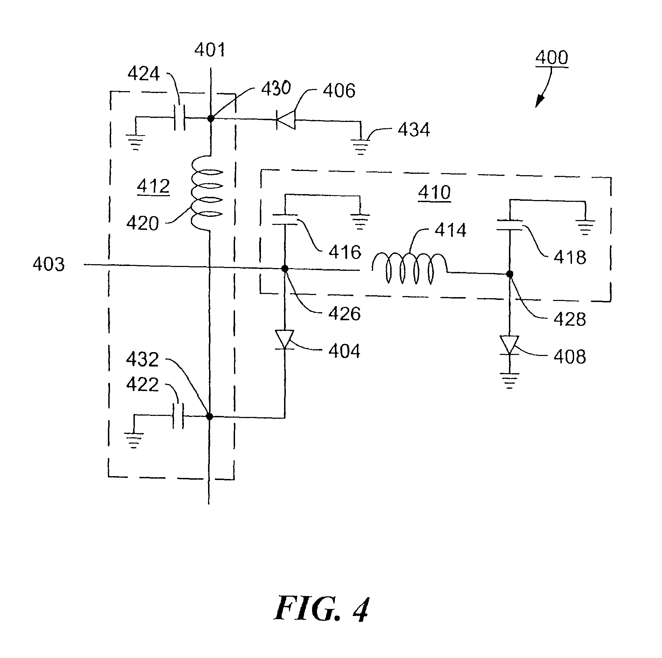

In some instances, it may be advantageous to provide a lumped circuit equivalent of the electrical length a quarter wavelength shorted stub between the associated nodes. Fig. 4 depicts a switching matrix node 400 that uses lumped circuit elements to provide the functionality of a quarter wavelength shorted stub. In particular, a quarter wavelength shorted stub can be simulated by lumped circuit that includes a pi-section configured using an inductor connected in series between two capacitors that are coupled from the respective inductor to ground. In particular, the signal input line 403 includes pi-section 410. Pi section 410 includes inductor 414 coupled in series between nodes 426 and 428, capacitor 416 coupled between node 426 and ground 434, and capacitor 418 coupled between node 428 and ground 434. The values for the inductor and each of the two capacitors are given by:

$$L = \frac{Z_0}{2\pi f_0} \qquad\qquad \text{Eq. 3}$$

$$C = \frac{1}{2\pi f_0 Z_0} \qquad\qquad \text{Eq. 4}$$

where $Z_0$ is the impedance of the transmission line, $f_0$ is the frequency of interest, L is in Henrys and C is in Farads.

Thus, to a signal propagating on input line 403, there appears to be a quarter-wavelength shorted stub coupled to node 426. Similarly, the signal output line 401 includes pi-section 412. Pi-section 412 includes inductor 420 coupled in series between nodes 430 and 432, capacitor 424 coupled between node 430 and ground 434, and capacitor 422 coupled between node 432 and ground. Thus, to a signal propagating on output line 401, there appears to be a quarter wavelength shorted stub coupled to node 432.

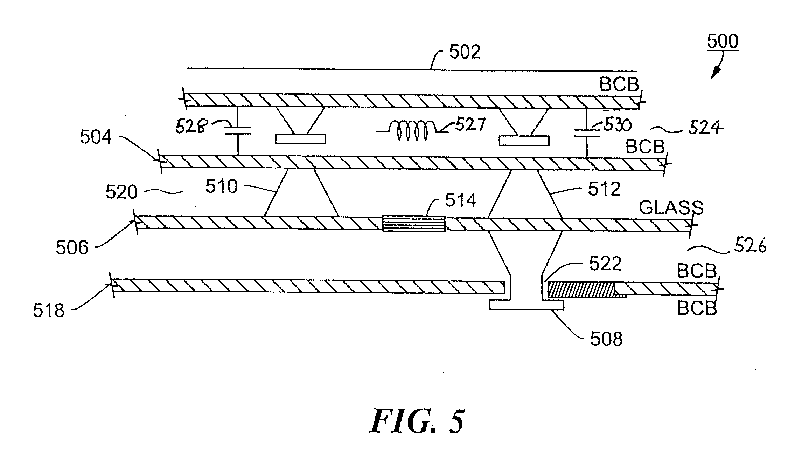

Fig. 5 depicts an embodiment for realizing the above described techniques and apparatus in a multilevel glass-based lumped circuit realization. In particular, the apparatus 500 is a multi-layer circuit layout 502 that includes a layer of substrate 520 in which a shunt diode 510 and an isolation diode 512 are disposed an equivalent of one-quarter wavelength apart at the center frequency of the signal of interest. The substrate 520 can be any suitable substrate that has a low dielectric constant, low loss tangent and high resistivity. In a preferred embodiment, the substrate 520 is glass. In the embodiment depicted in Fig. 5, the substrate 520 is etched and processed to provide semiconductor regions 510 and 512 therewithin and, in particular, to provide PIN diodes in these regions 510 and 512. The substrate 520 includes a pair of metallized layers 504 and 506 adjacent thereto so as to provide for the necessary signal conduction paths. A first layer of BCB (benzocyclobutine) 524 is provided on the top surface of metal layer 504 and a second layer of BCB 526 is provided on the bottom surface of metal layer 506. BCB provides a high impedance line such that at the frequencies of interest an inductor 527 is provided between the switching diode 510 and the isolation diode 512. Vias are provided in the BCB layer 524 and metal is deposited within the vias to provide capacitors 528 and 530. The values of the inductor 527 and the two capacitors 528 and 530 are selected to provide a lumped circuit realization of a quarter wavelength shorted stub tuner between the switching diode 510 and the isolation diode 512. Metal layer 506 includes a resistor 514. The second BCB layer 526 includes a via in which metal has been deposited and the shunt structure 508 formed. The shunt structure 508, which can be a feedthrough capacitor, includes a portion extending through an aperture in a third metal layer 518 which can be connected to a voltage reference (not shown) that is usually ground.

**Claims**

1. A switch matrix (100) comprising:

   a plurality of input lines (101,103)having a signal input end (126) and a non-input signal end (127);
   a plurality of output lines (105,107) having a signal output end (128) and a non-output signal end (129) ;
   a plurality of signal switches (102-108), each of which is coupled to one input line and to one output line such that, when a selected signal switch is activated, a signal of interest is connected between the input line coupled to the selected signal switch and the output line coupled to the selected switch;
   a plurality of first isolation switches (110-116), each of which is associated with one signal switch and is coupled to the output line (105,107) corresponding to the associated signal switch and to ground; and
   a plurality of second isolation switches (118-124), each of which is associated with one signal switch and is coupled to the input line (101,103) corresponding to the associated signal switch and to ground; **characterized in that**:

   each first isolation switch is coupled a first predetermined electrical length from the associated signal switch such that, when the first isolation switch is activated, the portion of the output line between the associated signal switch and the isolation switch forms a stub of the first predetermined electrical length; and
   each second isolation switch is coupled a second predetermined electrical length from the associated signal switch such that, when the second isolation switch is activated, the portion of the input line between the associated signal switch and the isolation switch forms a stub of the second predetermined electrical length.

2. The switch matrix of claim 1 wherein the switches (102-124) are semiconductor switching elements.

3. The switch matrix of claim 1 wherein the first isolation switches (110-116) are semiconductor switching elements.

4. The switch matrix of claim 2 or 3 wherein the semiconductor switching elements are selected from the group of switching diodes, thryristors and transistors.

5. The switch matrix of claim 4 wherein the switching diodes are PIN diodes.

6. The switch matrix of claim 4 or 5 wherein the transistors are bipolar junction transistors.

7. The switch matrix of claim 4 or 5 wherein the transistors are field effect transistors.

8. The switch matrix of any preceding claim wherein the first and/or second predetermined distance is an odd integer multiple of the quarter-wavelength of the signal of interest.

9. The switch matrix of any preceding claim wherein the first and/or second predetermined electrical distance is one-quarter wavelength of the signal of interest.

10. The switch matrix of claim 1 including a first electrical network (412) disposed in series between the one of the plurality of first isolation switches and the associated one of the signal switches, the first electrical network providing an impedance transformation equivalent to a shorted stub tuner of a first predetermined electrical length; and a second electrical network (410) disposed in series between the one of the plurality of second isolation switches and the corresponding one of the signal switches, the second electrical network providing an impedance transformation equivalent to a shorted stub tuner of a second predetermined electrical length.

**11.** The switch matrix of claim 10 wherein the first electrical network is a pi-section network (412).

**12.** The switch matrix of claim 10 or 11 wherein the second electrical network is a pi-section network (410).

**13.** The switch matrix of claim 12 comprising:

a first substrate (520) having top and bottom surfaces;
a first and second diode (510,512) disposed within the first substrate;
a first metal layer (524) having a top and bottom surface disposed on the top surface of the first substrate, wherein the bottom surface of the first metal layer is adjacent to the top surface of the first substrate;
a second metal layer (506) having a top and bottom surface disposed on the bottom surface of the first substrate, wherein the top surface of the second metal layer is adjacent to the bottom surface of the first substrate;
a second substrate (524) having a top surface and a bottom surface, the second substrate being formed adjacent to the top surface of the first metal layer, wherein the bottom surface of the second substrate is adjacent to the top surface of the first metal layer;
first and second capacitors (528,530)formed within the second substrate, forming a first pi-network, wherein the first pt-network provides an equivalent of a predetermined electrical length between the first and second diodes; and
a coupling for a voltage reference.

**14.** The switch matrix of claim 13 wherein the first predetermined electrical length is an odd integer number of quarter wavelengths of the center frequency of the signal of interest.

**15.** A method of isolating a switching connection in a switching matrix (100) having a plurality of signal switching devices (102-108), a plurality of signal input lines (101-103), and a plurality of signal output lines (105,107), wherein each of the plurality of signal switching devices couples one signal input line to one signal output line and wherein each of the plurality of signal switching devices divides each input line coupled thereto into a input side (126) and non-input side (127) and each output line coupled thereto into output and non-output sides (128,129), said method comprising the steps of:

selecting a signal input line (101,103)and a signal output line (105,107); and
activating a switching device (102,108) to couple the selected signal input line to the selected signal output line;
**characterised by**:

forming a first stub on the non-input side (127) of the selected signal input line, the first stub being coupled to ground at a first predetermined electrical length from the switching device; and
forming a second stub on the non-output side (129) of the selected signal output line, the second stub being coupled to ground at a second predetermined electrical length from the switching device.

**16.** The method of claim 15 wherein the switching step includes activating the corresponding signal switching device (102,108) to electrically connect the selected input line (101,103) and the selected output line (105,107).

**17.** The method of claim 15 or 16 wherein the switch matrix (100) further includes a plurality of first isolation switching devices (118,124), each of which corresponds to a signal switching device and is coupled to ground and to the non-input side (127) of the signal input line associated with the corresponding signal switching device at the first predetermined distance, and wherein the step of forming the first stub includes activating the isolation switching device corresponding to the signal switching device, whereupon the isolation switching device connects the selected signal input line to ground a predetermined distance away from the corresponding signal switching device, forming a shorted tuning stub on the non-input side of the selected signal input line.

**Patentansprüche**

**1.** Schaltmatrix (100), die Folgendes umfasst:

mehrere Eingangsleitungen (101, 103) mit einem Signaleingangsende (126) und einem Nicht-Eingang-Signalende (127);

mehrere Ausgangsleitungen (105, 107) mit einem Signalausgangsende (128) und einem Nicht-Ausgang-Signalende (129);

mehrere Signalschalter (102-108), die jeweils mit einer Eingangsleitung und einer Ausgangsleitung gekoppelt sind, so dass, wenn ein gewählter Signalschalter aktiviert wird, ein Signal von Interesse zwischen der mit dem gewählten Signalschalter gekoppelten Eingangsleitung und der mit dem gewählten Schalter gekoppelten Ausgangsleitung geschaltet wird;

mehrere erste Trennschalter (110-116), die jeweils mit einem Signalschalter assoziiert und mit der dem assoziierten Signalschalter entsprechenden Ausgangsleitung (105, 107) und mit Masse gekoppelt sind; und

mehrere zweite Trennschalter (118-124), die jeweils mit einem Signalschalter assoziiert und mit der dem assoziierten Signalschalter entsprechenden Eingangsleitung (101, 103) und mit Masse gekoppelt sind; **dadurch gekennzeichnet, dass**:

jeder erste Trennschalter in einem ersten vorbestimmten elektrischen Abstand von dem assoziierten Signalschalter gekoppelt ist, so dass, wenn der erste Trennschalter aktiviert wird, der Abschnitt der Ausgangsleitung zwischen dem assoziierten Signalschalter und dem Trennschalter eine Stichleitung der ersten vorbestimmten elektrischen Länge bildet; und

jeder zweite Trennschalter in einem zweiten vorbestimmten elektrischen Abstand von dem assoziierten Signalschalter gekoppelt ist, so dass, wenn der zweite Trennschalter aktiviert wird, der Abschnitt der Eingangsleitung zwischen dem assoziierten Signalschalter und dem Trennschalter eine Stichleitung der zweiten vorbestimmten elektrischen Länge bildet.

2. Schaltmatrix nach Anspruch 1, wobei die Schalter (102-124) Halbleiterschaltelemente sind.

3. Schaltmatrix nach Anspruch 1, wobei die ersten Trennschalter (110-116) Halbleiterschaltelemente sind.

4. Schaltmatrix nach Anspruch 2 oder 3, wobei die Halbleiterschaltelemente aus der Gruppe von Schaltdioden, Thyristoren und Transistoren ausgewählt sind.

5. Schaltmatrix nach Anspruch 4, wobei die Schaltdioden PIN-Dioden sind.

6. Schaltmatrix nach Anspruch 4 oder 5, wobei die Transistoren Bipolar-Flächentransistoren sind.

7. Schaltmatrix nach Anspruch 4 oder 5, wobei die Transistoren Feldeffekttransistoren sind.

8. Schaltmatrix nach einem der vorherigen Ansprüche, wobei die erste und/oder die zweite vorbestimmte Distanz ein ungerades ganzzahliges Vielfaches der Viertelwellenlänge des Signals von Interesse ist.

9. Schaltmatrix nach einem der vorherigen Ansprüche, wobei die erste und/oder die zweite vorbestimmte elektrische Distanz eine Viertelwellenlänge des Signals von Interesse ist.

10. Schaltmatrix nach Anspruch 1 mit einem ersten elektrischen Netzwerk (412), das in Reihe zwischen dem einen aus den mehreren ersten Trennschaltern und dem assoziierten einen der Signalschalter geschaltet ist, wobei das erste elektrische Netzwerk eine Impedanztransformation äquivalent mit einem kurzgeschlossenen Stichleitungstuner einer ersten vorbestimmten elektrischen Länge bildet; und

ein zweites elektrisches Netzwerk (410), das in Reihe zwischen dem einen der mehreren zweiten Trennschalter und dem entsprechenden einen der Signalschalter geschaltet ist, wobei das zweite elektrische Netzwerk eine Impedanztransformation äquivalent mit einem kurzgeschlossenen Stichleitungstuner einer zweiten vorbestimmten elektrischen Länge bereitstellt.

11. Schaltmatrix nach Anspruch 10, wobei das erste elektrische Netzwerk ein Pi-Sektionsnetzwerk (412) ist.

12. Schaltmatrix nach Anspruch 10 oder 11, wobei das zweite elektrische Netzwerk ein Pi-Sektionsnetzwerk (410) ist.

13. Schaltmatrix nach Anspruch 12, die Folgendes umfasst:

ein erstes Substrat (520) mit einer Ober- und einer Unterseite;

eine erste und eine zweite Diode (510, 512), die in dem ersten Substrat angeordnet sind;

eine erste Metallschicht (524) mit einer Ober- und einer Unterseite, die auf der Oberseite des ersten Substrats angeordnet ist, wobei die Unterseite der ersten Metallschicht neben der Oberseite des ersten Substrats liegt;

eine zweite Metallschicht (506) mit einer Ober- und einer Unterseite, die auf der Unterseite des ersten Substrats angeordnet ist, wobei die Oberseite der zweiten Metallschicht neben der Unterseite des ersten Substrats liegt;

ein zweites Substrat (524) mit einer Oberseite und einer Unterseite, wobei das zweite Substrat neben der Oberseite der ersten Metallschicht ausgebildet ist, wobei die Unterseite des zweiten Substrats neben der Oberseite der ersten Metallschicht liegt;

einen ersten und einen zweiten Kondensator (528, 530), die in dem zweiten Substrat ausgebildet sind und ein erstes Pi-Netzwerk bilden, wobei das erste Pi-Netzwerk ein Äquivalent einer vorbestimmten elektrischen Länge zwischen der ersten und der zweiten Diode bildet; und

eine Kopplung für eine Spannungsreferenz.

14. Schaltmatrix nach Anspruch 13, wobei die erste vorbestimmte elektrische Länge eine ungerade ganzzahlige Anzahl von Viertelwellenlängen der Mittenfrequenz des Signals von Interesse ist.

15. Verfahren zum Trennen einer Schaltverbindung in einer Schaltmatrix (100) mit mehreren Signalschaltvorrichtungen (102-108), mehreren Signaleingangsleitungen (101-103) und mehreren Signalausgangsleitungen (105, 107), wobei jede der mehreren Signalschaltvorrichtungen eine Signaleingangsleitung mit einer Signalausgangsleitung koppelt und wobei jede der mehreren Signalschaltvorrichtungen jede damit gekoppelte Eingangsleitung in eine Eingangsseite (126) und eine Nicht-Eingangsseite (127) unterteilt und jede damit gekoppelte Ausgangsleitung in eine Ausgangs- und eine Nicht-Ausgangsseite (128, 129) unterteilt, wobei das Verfahren die folgenden Schritte beinhaltet:

Wählen einer Signaleingangsleitung (101, 103) und einer Signalausgangsleitung (105, 107); und

Aktivieren einer Schaltvorrichtung (102, 108) zum Koppeln der gewählten Signaleingangsleitung mit der gewählten Signalausgangsleitung; **gekennzeichnet durch**:

Bilden einer ersten Stichleitung auf der Nicht-Eingangsseite (127) der gewählten Signaleingangsleitung, wobei die erste Stichleitung mit Masse in einem ersten vorbestimmten elektrischen Abstand von der Schaltvorrichtung gekoppelt ist; und

Bilden einer zweiten Stichleitung auf der Nicht-Ausgangsseite (129) der gewählten Signalausgangsleitung, wobei die zweite Stichleitung mit Masse in einem zweiten vorbestimmten elektrischen Abstand von der Schaltvorrichtung gekoppelt ist.

16. Verfahren nach Anspruch 15, wobei der Schaltschritt das Aktivieren der entsprechenden Signalschaltvorrichtung (102, 108) beinhaltet, um die gewählte Eingangsleitung (101, 103) und die gewählte Ausgangsleitung (105, 107) elektrisch zu verbinden.

17. Verfahren nach Anspruch 15 oder 16, wobei die Schaltmatrix (100) ferner mehrere erste Trennschaltvorrichtungen (118, 124) aufweist, die jeweils einer Signalschaltvorrichtung entsprechen und mit Masse und mit der Nicht-Eingangsseite (127) der Signaleingangsleitung gekoppelt sind, die mit der Signalschaltvorrichtung in der ersten vorbestimmten Entfernung assoziiert ist, und wobei der Schritt des Bildens der ersten Stichleitung das Aktivieren der der Signalschaltvorrichtung entsprechenden Trennschaltvorrichtung beinhaltet, wonach die Trennschaltvorrichtung die gewählte Signaleingangsleitung mit Masse in einer vorbestimmten Entfernung von der entsprechenden Signalschaltvorrichtung verbindet und eine kurzgeschlossene Anpassstichleitung auf der Nicht-Eingangsseite der gewählten Signaleingangsleitung bildet.

## Revendications

1. Matrice de commutation (100), comprenant :

plusieurs lignes d'entrée (101, 103), comportant une extrémité d'entrée des signaux (126) et une extrémité de non-entrée des signaux (127) ;

plusieurs lignes de sortie (105, 107), comportant une extrémité de sortie des signaux (128) et une extrémité de non-sortie des signaux (129) ;

plusieurs commutateurs de signaux (102-108), chacun étant accouplé à une ligne d'entrée et à une ligne de sortie, de sorte que lors de l'actionnement d'un commutateur de signaux sélectionné, un signal d'intérêt est connecté entre la ligne d'entrée accouplée au commutateur de signaux sélectionné et la ligne de sortie accouplée au commutateur sélectionné ;

plusieurs premiers commutateurs d'isolation (110-116), chacun étant associé à un commutateur de signaux et étant accouplé à la ligne de sortie (105, 107) correspondant au commutateur de signaux associé et à la masse ; et

plusieurs deuxièmes commutateurs d'isolation (118-124), chacun étant associé à un commutateur de signaux et étant accouplé à la ligne d'entrée (101, 103) correspondant au commutateur de signaux associé et à la masse ; **caractérisée en ce que** :

chaque premier commutateur d'isolation est accouplé à une première longueur électrique prédéterminée à partir du commutateur de signaux associé, de sorte que lors de l'actionnement du premier commutateur d'isolation, la partie de la ligne de sortie située entre le commutateur de signaux associé et le commutateur d'isolation forme un bras de réactance de la première longueur électrique prédéterminée ; et

chaque deuxième commutateur d'isolation est accouplé à une deuxième longueur électrique prédéterminée à partir du commutateur de signaux associé, de sorte que lors de l'actionnement du deuxième commutateur d'isolation, la partie de la ligne d'entrée située entre le commutateur de signaux associé et le commutateur d'isolation forme un bras de réactance de la deuxième longueur électrique prédéterminée.

**2.** Matrice de commutation selon la revendication 1, dans laquelle les commutateurs (102-124) sont constitués par des éléments de commutation à semi-conducteurs.

**3.** Matrice de commutation selon la revendication 1, dans laquelle les premiers commutateurs d'isolation (110-116) sont constitués par des éléments de commutation à semi-conducteurs.

**4.** Matrice de commutation selon les revendications 2 ou 3, dans laquelle les éléments de commutation à semi-conducteurs sont sélectionnés à partir du groupe constitué de diodes de commutation, de thyristors et de transistors.

**5.** Matrice de commutation selon la revendication 4, dans laquelle les diodes de commutation sont des diodes PIN.

**6.** Matrice de commutation selon les revendications 4 ou 5, dans laquelle les transistors sont des transistors à jonctions bipolaires.

**7.** Matrice de commutation selon les revendications 4 ou 5, dans laquelle les transistors sont des transistors à effet de champ.

**8.** Matrice de commutation selon l'une quelconque des revendications précédentes, dans laquelle la première et/ou la deuxième distance prédéterminée constitue un multiple entier impair du quart de la longueur d'onde du signal d'intérêt.

**9.** Matrice de commutation selon l'une quelconque des revendications précédentes, dans laquelle la première et/ou la deuxième distance électrique prédéterminée représente un quart de la longueur d'onde du signal d'intérêt.

**10.** Matrice de commutation selon la revendication 1, englobant un premier réseau électrique (412) agencé en série entre l'un des plusieurs premiers commutateurs d'isolation et le commutateur associé des commutateurs de signaux, le premier réseau électrique assurant une transformation d'impédance équivalent à un bras de réactance syntoniseur en court-circuit d'une première longueur électrique prédéterminée ; et

un deuxième réseau électrique (410) agencé en série entre l'un des plusieurs commutateurs d'isolation et le commutateur correspondant des commutateurs de signaux, le deuxième réseau électrique assurant une transformation d'impédance équivalent à un bras de réactance syntoniseur en court-circuit d'une deuxième longueur électrique prédéterminée.

**11.** Matrice de commutation selon la revendication 10, dans laquelle le premier réseau électrique est un réseau à section en pi (412).

**12.** Matrice de commutation selon les revendications 10 ou 11, dans laquelle le deuxième réseau électrique est un réseau à section en pi (410).

**13.** Matrice de commutation selon la revendication 12, comprenant :

un premier substrat (520) comportant des surfaces supérieure et inférieure ;

des première et deuxième diodes (510, 512) agencées dans le premier substrat ;

une première couche métallique (524) comportant une surface supérieure et une surface inférieure agencée sur la surface supérieure du premier substrat, la surface inférieure de la première couche métallique étant adjacente à la surface supérieure du premier substrat ;

une deuxième couche métallique (506), comportant une surface supérieure et une surface inférieure, agencée sur la surface inférieure du premier substrat, la surface supérieure de la deuxième couche métallique étant adjacente à la surface inférieure du premier substrat ;

un deuxième substrat (512) comportant une surface supérieure et une surface inférieure, le deuxième substrat étant formé près de la surface supérieure de la première couche métallique, la surface inférieure du deuxième substrat étant adjacente à la surface supérieure de la première couche métallique ;

des premier et deuxième condensateurs (528, 530) formés dans le deuxième substrat, formant un premier réseau en pi, le premier réseau en pi établissant un équivalent d'une longueur électrique prédéterminée entre les première et deuxième diodes ; et

un accouplement pour une référence de tension.

14. Matrice de commutation selon la revendication 13, dans laquelle la première longueur électrique prédéterminée correspond à un nombre entier impair de quarts de longueurs d'ondes de la fréquence centrale du signal d'intérêt.

15. Procédé d'isolation d'une connexion de commutation dans une matrice de commutation (100), comportant plusieurs dispositifs de commutation de signaux (102-108), plusieurs lignes d'entrée des signaux (101-103), et plusieurs lignes de sortie des signaux (105, 107), chacun des plusieurs dispositifs de commutation des signaux accouplant une ligne d'entrée des signaux à une ligne de sortie des signaux, chacun des plusieurs dispositifs de commutation des signaux divisant chaque ligne d'entrée qui y est accouplée en un côté d'entrée (126) et un côté de non-entrée (127) et chaque ligne de sortie qui y est accouplée en des côtés de sortie et de non-sortie (128, 129), ledit procédé comprenant les étapes ci-dessous :

sélection d'une ligne d'entrée des signaux (101, 103) et d'une ligne de sortie des signaux (105, 107); et

actionnement d'un dispositif de commutation (102, 108) pour accoupler la ligne d'entrée des signaux sélectionnée à la ligne de sortie des signaux sélectionnée ; **caractérisé par** :

la formation d'un premier bras de réactance sur le côté de non-entrée (127) de la ligne d'entrée des signaux sélectionnée, le premier bras de réactance étant accouplé à la masse au niveau d'une première longueur électrique prédéterminée par rapport au dispositif de commutation ; et

la formation d'un deuxième bras de réactance sur le côté de non-entrée (129) de la ligne de sortie des signaux sélectionnée, le deuxième bras de réactance étant accouplé à la masse au niveau d'une deuxième longueur électrique prédéterminée par rapport au dispositif de commutation.

16. Procédé selon la revendication 15, dans lequel l'étape de commutation englobe l'actionnement du dispositif de commutation de signaux correspondant (102, 108) pour assurer la connexion électrique de la ligne d'entrée sélectionnée (101, 103) et de la ligne de sortie sélectionnée (105, 107).

17. Procédé selon les revendications 15 ou 16, dans lequel la matrice de commutation (100) englobe en outre plusieurs premiers dispositifs de commutation d'isolation (188, 124), chacun correspondant à un dispositif de commutation des signaux et étant accouplé à la masse et au côté de non-entrée (127) de la ligne d'entrée des signaux associée au dispositif de commutation des signaux correspondant au niveau de la première distance prédéterminée, l'étape de formation du premier bras de réactance englobant l'actionnement du dispositif de commutation d'isolation correspondant au dispositif de commutation des signaux, le dispositif de commutation d'isolation assurant la connexion de la ligne d'entrée des signaux sélectionnée à la masse, à une distance prédéterminée du dispositif de commutation des signaux correspondant, formant un bras de réactance syntoniseur en court-circuit sur le côté de non-entrée de la ligne d'entrée des signaux sélectionnée.

**FIG. 1**

EP 1 298 857 B1

**FIG. 2**

13

*FIG. 3*

*FIG. 4*

*FIG. 5*

**EP 1 298 857 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 0683538 A